Europäisches Patentamt

European Patent Office

Office européen des brevets

(11) Publication number: **0 312 200**
**A2**

## (12) EUROPEAN PATENT APPLICATION

(21) Application number: 88307742.2

(22) Date of filing: 22.08.88

(51) Int. Cl.⁴: **H03M 13/12**

(30) Priority: 13.10.87 GB 8723977

(43) Date of publication of application:
**19.04.89 Bulletin 89/16**

(84) Designated Contracting States:
**AT BE CH DE ES FR GR IT LI LU NL SE**

(71) Applicant: **BRITISH BROADCASTING
CORPORATION**
**Broadcasting House**
**London W1A 1AA(GB)**

(72) Inventor: **Newland, Jonathan David**
**66 Eridge Road Croydon**
**Surrey, CRO 1EF(GB)**

(74) Representative: **Pears, David Ashley et al**
**REDDIE & GROSE 16 Theobalds Road**
**London WC1X 8PL(GB)**

(54) **Synchroniser for a decoder and decoder system.**

(57) Convolutionally encoded data signals $(I', Q')$ that have been demodulated after synchronous transmission may well be phase ambiguous depending on the phase of the recovered carrier signal. To ensure correct decoding by a Viterbi or similar probabilistic decoder (30) the demodulated data is synchronised by a synchroniser (9). The demodulated data is first hard-limited (10) and then fed to a matrix (13) to form groups of bits corresponding to each possible phase of the recovered carrier. A sequence of combinations corresponding to one phase is selected by a switch (15) and compared with allowable sequences stored in a memory (22). A controller (17) maintaining an error count monitors the number of unallowable combinations in the sequence and if it reaches a preset level determines that there is a phase error and selects a combination representing a different recovered carrier phase by stepping on the switch (15). A second switch (28) operated in sympathy with the switch (15) selects the correct input combination to the decoder (30) from a quantiser (26) and a matrix (27).

FIG.3

Xerox Copy Centre

## SYNCHRONISER FOR A DECODER AND DECODER SYSTEM

This invention relates to a synchroniser for synchronising demodulated data signals which have been transmitted synchronously, for example for enabling correct decoding by a Viterbi or other decoder. The invention also relates to a decoder system.

The Viterbi decoder decodes data encoded by a convolutional encoder. A carrier signal is recovered from the synchronous data signals and used to demodulate these signals and obtain raw coded data. The original data is decoded from the raw coded data on the basis of maximum a posteriori probability solving the problem of finding the state sequence for which the conditional probability of a given state sequence occurring is a maximum, given that another state sequence has already occurred. The Viterbi algorithm can be equated to seeking the shortest route, as measured by a branch metric calculator, through a trellis in which each node represents a state at a given time and each branch represents a transition to some new state at the next instant of time. For every possible state sequence there corresponds a unique path through the trellis, and vice versa. As an example, consider a node where two possible received branches 1011 and 1110 meet. The actual received data is, say, 1001. This represents a distance of 2 from 1110 and a distance of 1 from 1011. The Viterbi algorithm will discard the longer distance and consider the received signal to be a form of 1011 that has been corrupted by one bit, for example due to noise.

The synchroniser for a Viterbi decoder must take data from the demodulator and format it suitably for the branch metric calculator, which determines the path distances as explained. If the incoming data is not suitably formatted, that is, the decoder is not synchronised, then all path metrics have about the same value, so that no optimum path through the trellis can be determined, and the survivors (the undiscarded shortest paths at any node) never merge at the end point of the trellis. Particular problems arise with data streams transmitted using phase or phase difference modulation techniques as the demodulator can demodulate the received signal in the wrong phase. Most commercial Viterbi decoders achieve locking by monitoring the path metrics or the merging properties of the trellis, but cease to function correctly at fairly high noise levels, e.g. an output bit error ratio of 1 x $10^{-3}$.

The present invention provides a simple synchroniser for a decoder and is defined in claim 1.

A synchroniser embodying the invention is suitable for use with a Viterbi decoder and has the advantages of simplicity of construction combined with the ability to extract signals under very noisy conditions. In one embodiment, with a Viterbi decoder of constraint length six the decoder can remain in lock for bit error ratios of up to 7 x $10^{-2}$.

Embodiments of the invention will now be described by way of example and with reference to the accompanying drawings; wherein:

Figure 1 is a schematic representation of a quadrature phaseshift key (QPSK) modem;

Figures 2a - 2d shows the possible phase ambiguities that can arise in the recovered carrier with a QPSK modulated signal;

Figure 3 is a block diagram of a synchroniser embodying the invention;

Figure 4 is a flow diagram showing the sequence of operational performed by the controller of Figure 3; and

Figures 5a - 5d show how the invention may be applied to BPSK modulation.

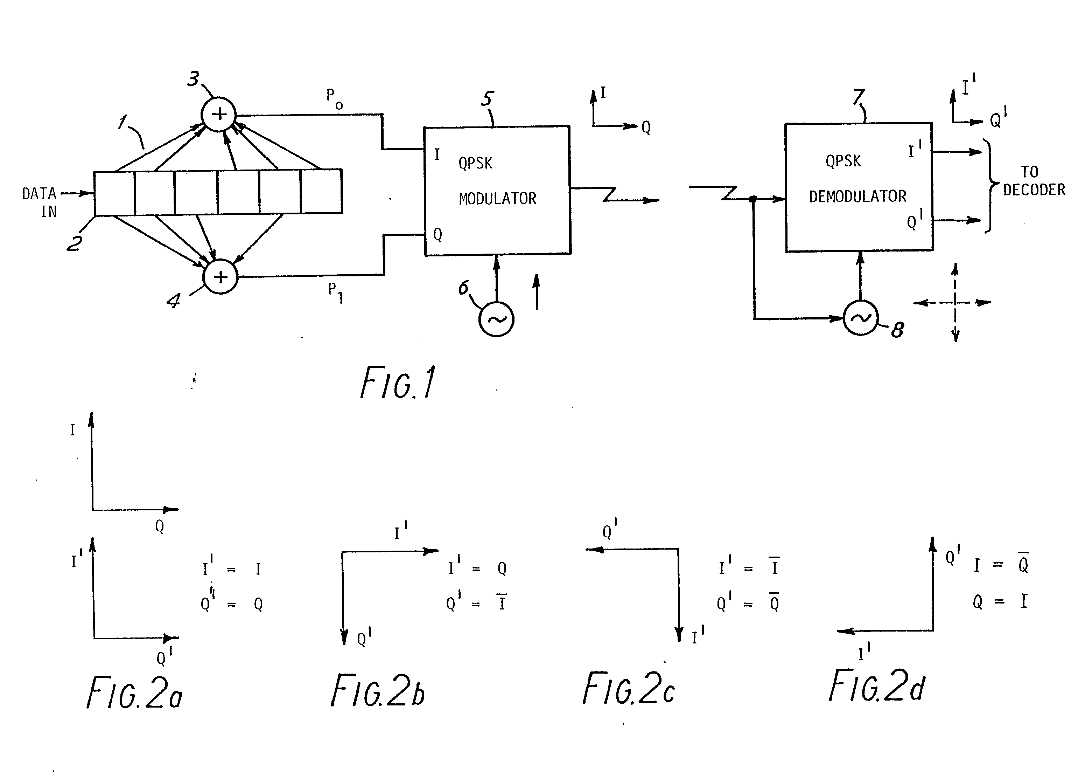

A conventional encoder 1 (Figure 1) comprises a six bit shift register 2, whose contents are bits $B_0$ to $B_5$, and two modulo-2 adders 3 and 4. The adders are connected to the shift register so that adder 3 produces an output bit $P_0 = (B_0 + B_1 + B_3 + B_4 + B_5)$ MOD 2, that is a generator $G_0 = 110111$, and adder 4 produces an output bit $P_1 = (B_0 + B_1 + B_2 + B_4)$ MOD 2, that is generator $G_1 = 111010$. The encoder has constraint length 6 and a code rate $\frac{1}{2}$, with a 1 bit input sequence. The conventional encoder shown in this example is one of many possible encoders, a full explanation of the operation of which may be found in Digital Communication by J.G. Proakis published by McGraw Hill 1983, for example.

The 2-bit parity word output $P_0P_1$ from the encoder is fed to a two channel QPSK modulator 5. The carrier frequency is generated by an oscillator 6 and the carrier phase is modulated by the I and Q channels. $P_0$ modulating the I channel and $P_1$ modulating the Q channel; the two channels are transmitted 90° out of phase with one another.

The QPSK demodulator 7 regenerates the carrier frequency from the received data, as symbolised at 8. With the carrier regenerated the demodulator uses synchronous demodulation to recover the data in its encoded form.

QPSK has four rest phases at 0°, 90°, 180° and 270°. The recovered carrier can lock into any one of these phases. If the phase locked onto is not that on which the carrier was transmitted, a phase ambiguity (i.e. a phase error) of 90, 180 or 270° will arise, depending onto which phase the carrier locks.

Figures 2a-2d show how phase ambiguity has the effect of interchanging and inverting the I and Q channels. In Figure 2a, where there is no phase error $I'$ and $Q'$ (the apparent I and Q that are recovered) correspond respectively to I and Q as sent. Figure 2b shows the situation where there is $270°$ (or $-90°$) phase error; the $I'$ and $Q'$ vectors have been rotated so that $I'$ is received as Q and $Q'$ is received as I. With a $180°$ phase error as shown in Figure 2c, both I and Q are inverted so that $I' = I$ and $Q' = Q$. Figure 2d shows a $90°$ error with $I' = Q$ and $Q' = I$.

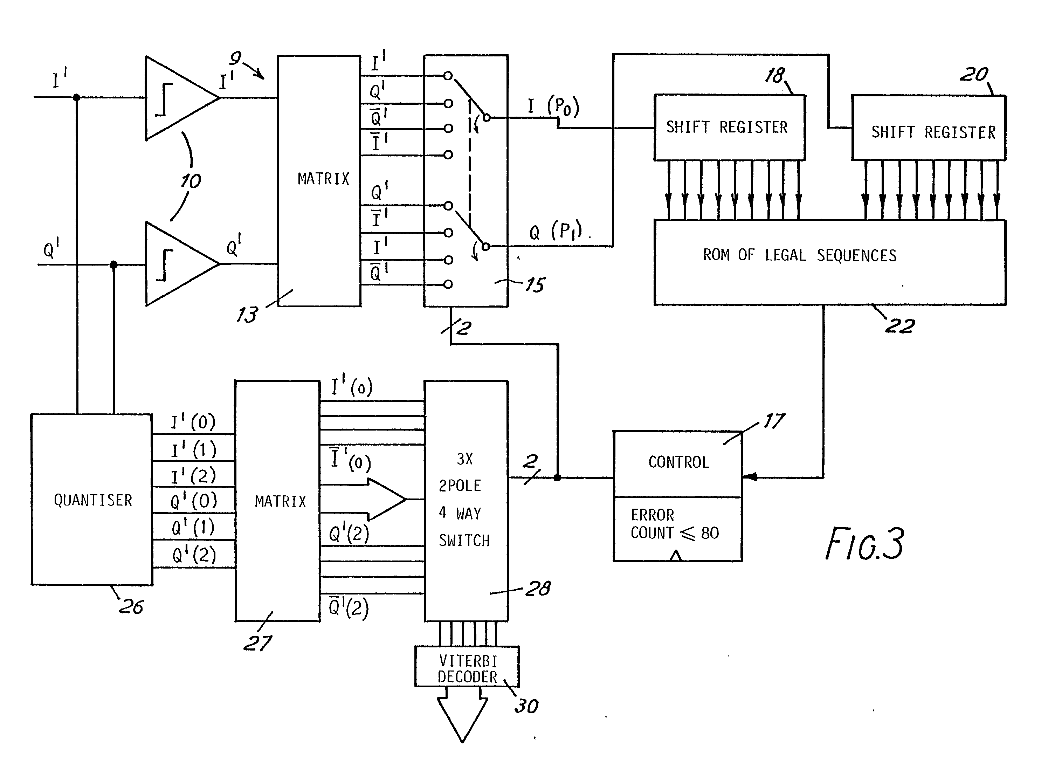

If the Viterbi decoder attempted to decode the phase ambiguous signals, the branches of the trellis would never merge as the path lengths would all tend to be of the same length. To overcome this problem the hard-decision synchroniser 9 of Figure 3 is used in parallel with the Viterbi decoder to determine the correct phase of the regenerated carrier to enable the decoder to decode effectively.

Describing the synchronising part of the circuit first, the received $I'$ and $Q'$ data are first limited by hard decision limiters 10 which quantise the received information by sampling at the greatest eye height, each bit of a received encoded pair $P_0' P_1'$ being quantised to the levels, 0 and 1. The limited quantised signal is then fed into a matrix 13 which creates the inverses of the data and produces a set of outputs $I' Q' Q' $ and $I'$ for the I channel and a set of outputs $Q' I' I' Q$ for the Q channel. An output from each set of outputs is selected by a 2-pole 4-position switch 15. The switch poles are ganged so that the same position output is selected for the I and Q channels. It will be seen that the outputs are arranged so that the selected pairs of outputs correspond to the various possible phase ambiguities. As an example, $I = Q'$ and $Q = I'$ correspond to a $-90°$ phase ambiguity (Figure 2b). The position of the two pole switch is controlled by a two bit signal from a system controller 17 which will be described in greater detail in due course.

For the sake of convenience it will be assumed that the switch has been set to the correct position so that the outputs from the switch can be referred to as I and Q, as they correctly reflect the data transmitted on the I and Q channels. These outputs form a parity word $P_0, P_1$.

The I and Q outputs are fed into respective 9 bit shift registers 18 and 20 where they form an 18 bit address to a read only memory (ROM) 22. The ROM 22 is in effect a 1-bit wide look-up table in which is stored a directory of legal sequences, that is, sequences of data in the shift register that correspond to a correct phase demodulated signal. The 18 bit address represents a sequence and the memory produces a 'legal' or 'error' output signal (e.g. a 1 bit and a 0 bit respectively) depending on whether or not the sequence is legal.

To judge between legal and error sequences of parity words, the sequences must be longer than the constraint length of the convolutional encoder. We have found that a sequence length of 9 is suitable for a constraint length of 6.

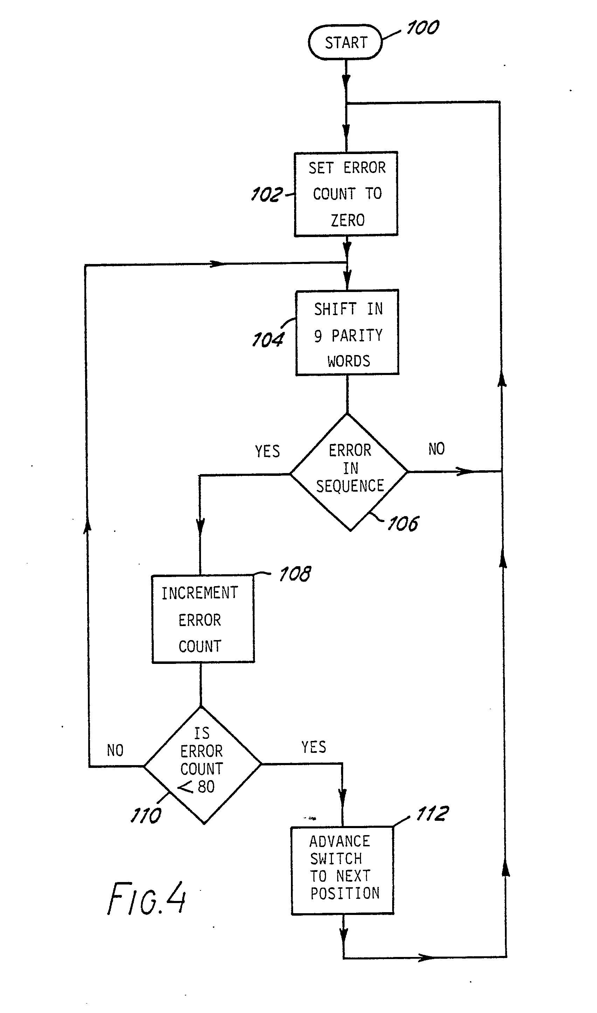

The output signal from the ROM 22 is fed into the system controller, operation of which will now be described with reference to Figure 4.

Given that with the presence of noise in any electrical system, errors are bound to occur in the decoded data stream, the advent of a single error signal from the ROM 22 is not conclusive evidence that there is a phase ambiguity in the decoded data. The controller therefore includes an error counter 24 that is incremented every time an error signal is received from the ROM 22. Only when the error count reaches a certain level does the controller decide that there are too many errors for the carrier to be locked up in the correct phase.

The sequence of events in the controller is as follows: after start up (100), at step 102, the error counter in the controller is set to zero. At step 104, the next nine decoded parity word s are shifted into the shift registers 18 and 20 which address the ROM 22. (There is of course a start-up interval during which the first nine parity words are shifted into the registers 18, 20. Once the system is running, these registers always hold the most recent nine parity words). At step 106, the ROM outputs its 'legal' or 'error' decision. If there is no error in the sequence, the controller reverts to step 102 and the procedure is repeated. If there is an error in the sequence, the error counter is incremented by 1 at step 108. The controller, at step 110 compares the newly incremented error count with a fixed number (80 in the example) and if the count is below that number returns the procedure to step 104, shifting a new parity word into the ROM 22. If the error count is equal to 80, then there are sufficient errors to indicate a phase ambiguity. The controller then increments a 2 bit address signal fed to the 2-pole 4-way switch to move the poles to the next position and the control procedure is restarted. The two bit address is also sent to the Viterbi decoder as will now be described.

It will be appreciated that the circuit of Figure 3 is synchronised with the recovered carrier or clock signal which, in particular, controls the shift operations of the registers 18, 20.

Referring back to Figure 3 it will be remembered that the Viterbi decoder 30 requires demodulated data to be fed in with the correct phase. Therefore the data input to the decoder must be rearranged to compensate for the possible phase ambiguities. Similarly to the synchroniser the input to the Viterbi decoder is first quantised by quantiser 26 and then fed into a matrix 27 where the data and the inverses thereof are used to create sets of bits for the I and Q channels. The data is quantised as a three bit code and the matrix 27 is in effect three of the matrices 13 arranged in parallel and having a total of six four pole outputs, one each of each bit I(0), I(1), I(2) and Q(0), Q(1), Q(2), of the quantised signal. The outputs of the matrix are connected to a 3 x 2 pole 4-way switch 28 which is controlled by the 2-bit signal from the system controller to that switch position which corresponds to the selected position of the switch 15. Thus, for example, if the switch 15 selects $I = Q'$ and $Q = I'$, the switch 28 selects $I(0,1,2) = Q'(0,1,2)$ and $Q(0,1,2) = I'(0,1,2)$. In this way it is ensured that an unambiguous data stream I(0,1,2), Q(0,1,2) is fed to the Viterbi decoder 30 so that the decoding operation can be accurately carried out even under conditions of considerable noise.

The system has been described in relation to a QPSK modem. However, it is suitable for use with other modulation systems. With more than four phases, for example, the matrix would require modification as the output phase constellations could not be produced simply by taking the inverses of the received data on the I and Q channels.

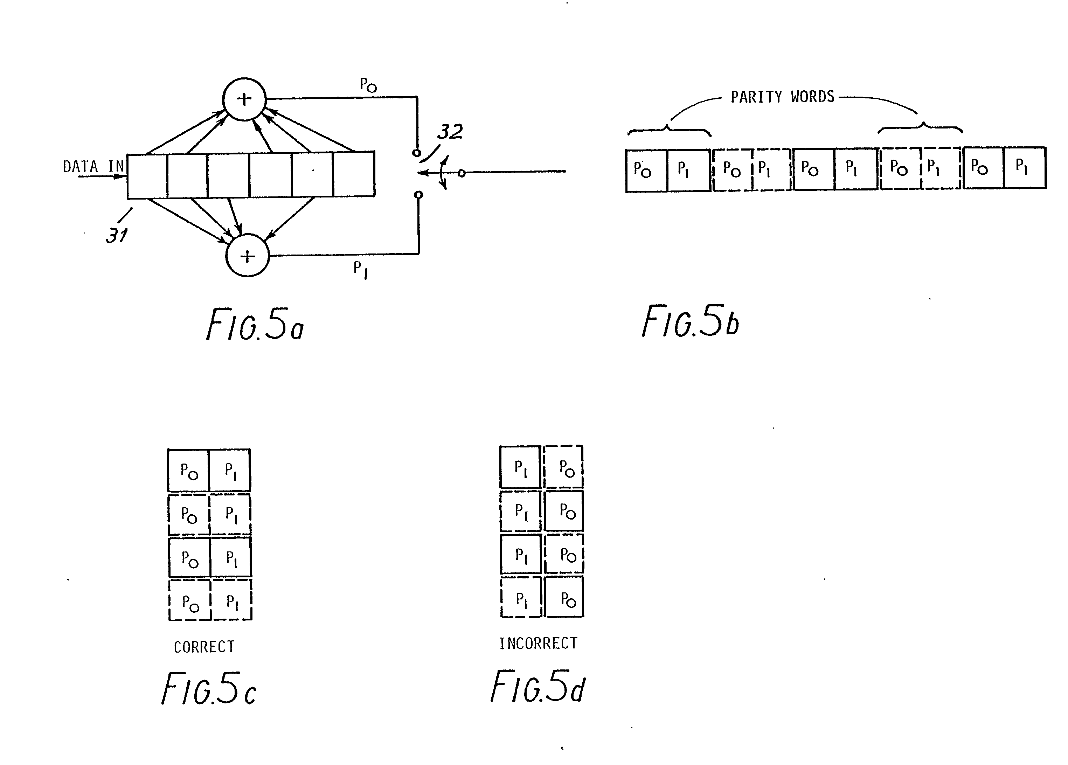

Figure 5 shows how the system may be applied to a BPSK (Binary Phase Shift Keyed) modem.

Figure 5a shows the convolutional encoder 31 that produces parity words $P_0 P_1$. The coding is the same as the encoder shown in Figure 1, that is $P_0$ is produced from a generator $G_0 = 110111$ and $P_1$ from generator $G_1 = 111010$. The parity bits are transmitted by a switch 32 that polls the outputs at twice the data rate so that for each data bit fed into the shift register of the encoder a bit-serial parity word $P_0 P_1$ is transmitted. It will be appreciated that the recovered data stream will be a serial stream of parity bits $P_0 P_1 P_0 P_1$ etc. as shown in Figure 5b. These words must be converted into parallel form as shown in Figures 5c and 5d and, depending on where the data stream is broken, will either be parallel words $P_1 P_0$ (incorrect) as shown in Figure 5c or $P_0 P_1$ (correct) as shown in Figure 5d. Although the problem appears to be one of synchronising the timing it is essentially a question of synchronising the phase of a signal at half the carrier frequency.

The system of Figure 3 could easily be modified to cope with BPSK synchronisation. Instead of determining which of four rest phases the data was transmitted the synchroniser would have to determine on which of two phases of the sub-carrier the data was transmitted.

The invention can be used with other types of decoders for convolutionally encoded data, examples of which are given in the aforementioned book by Proakis.

## Claims

1. A synchroniser for synchronising data signals demodulated from a phase ambiguous recovered carrier signal or sub-multiple thereof, comprising means (26) for quantising groups of demodulated data bits, a first matrix (13) for generating from the quantised groups all combinations of bits corresponding to the different possible phases of the recovered carrier, first means 15 for selecting from the first matrix a combination corresponding to one possible carrier phase, means (18, 20, 22) for comparing a sequence of a given number of selected combinations corresponding to that one phase with predetermined allowable sequences of combinations and for producing a signal indicative of whether each sequence of combinations is allowable, control means (17) for adjusting the first selecting means to select a fresh combination corresponding to a different carrier phase when the number of unallowable sequences occurring indicates that the current selected combination is not correct, and means (27, 28) for adapting a decoder operating on the demodulated data signals to match the selected combination.

2. A synchroniser according to claim 1, characterised in that the control means (17) select a fresh combination when a predetermined number of unallowable sequences are detected in succession.

3. A synchroniser according to claim 1 or 2, characterised in that the means for adapting the decoder comprise a second matrix (27) for generating from combinations of quantised demodulated bits for the decoder all combinations of bits corresponding to the different possible phases of the recovered carrier, and second selecting means (28) for selecting combinations from the second matrix corresponding to the same phase as those combinations selected from the first matrix and for inputting the selected combinations to the decoder.

4. A synchroniser according to any of claims 1 to 3, characterised in that the comparing means comprises a memory (22) having allowable sequences of combinations stored therein and a shift register device (18, 20) for holding the sequence of selected combinations and into which the selected combinations are shifted sequentially, the memory (22) being addressed by the shift register device, and storing at each address a signal indicative of whether the sequence of combinations forming the address is an allowable sequence.

5. A decoder system for a convolutionally coded, a synchronously transmitted digital signal, comprising a carrier recovery circuit (8) for recovering a phase-ambiguous carrier signal from the received signal, a demodulator (7) responsive to the received signal and the recovered carrier signal to provide first groups of bits $(I', Q')$ to a Viterbi or other probabilistic decoder (30), and means (10) for deriving second, more coarsely quantised groups of bits $(I', Q')$ from the output of the demodulator, characterised by a first matrix (13) for creating from the second groups of bits all combinations of bits $(I', Q', I', Q')$ corresponding to the different possible carrier phases, first switching means (15) for selecting one of the combinations, by means (18, 20, 22) for continuously testing the most recent n selected combinations, where n is an integer greater than the constraint length of the convolutional code to determine when any such sequence is illegal, by means (17) responsive to the testing means to operate the first switching means to that setting which minimises the occurrence of illegal sequences, by a second matrix (27) for creating from the first groups of bits all combinations of bits corresponding to the different possible carrier phases, and by second switching means (28) operating in sympathy with the first switching means (15) for selecting one of the combinations of bits from the second matrix as the input to the probabilistic decoder (30).

DATA
IN

$P_o$

$P_1$

I QPSK MODULATOR Q

I

Q

QPSK DEMODULATOR

I'

Q'

TO DECODER

I'

Q'

*FIG.1*

$\begin{aligned} I' &= I \\ Q' &= Q \end{aligned}$

*FIG.2a*

$\begin{aligned} I' &= Q \\ Q' &= \bar{I} \end{aligned}$

*FIG.2b*

$\begin{aligned} I' &= \bar{I} \\ Q' &= \bar{Q} \end{aligned}$

*FIG.2c*

$\begin{aligned} I' &= \bar{Q} \\ Q' &= I \end{aligned}$

*FIG.2d*

FIG.3

EP 0 312 200 A2

FIG.4

FIG.5a

FIG.5b

PARITY WORDS

CORRECT

FIG.5c

INCORRECT

FIG.5d

EP 0 312 200 A2